# EUROPÄISCHE PATENTSCHRIFT

(11) **EP 0 885 462 B1**
(45) Veröffentlichungstag und Bekanntmachung des Hinweises auf die Patenterteilung: **03.05.2000**
(21) Anmeldenummer: 97917260.8
(22) Anmeldetag: 05.03.1997
(51) Int. Cl.: H01L 39/22

(54) **SUPRALEITER/HALBLEITER/SUPRALEITER-STUFENKONTAKT**
SUPERCONDUCTOR/SEMICONDUCTOR/SUPERCONDUCTOR STEPPED CONTACT
CONTACT A GRADIN SUPRACONDUCTEUR/SEMICONDUCTEUR/SUPRACONDUCTEUR

(30) Priorität: 07.03.1996 DE 19608564
(43) Veröffentlichungstag der Anmeldung: 23.12.1998
(73) Patentinhaber: FORSCHUNGSZENTRUM JÜLICH GMBH, 52425 Jülich (DE)
(72) Erfinder: KASTALSKY, Alexander, Wayside, NJ 07712 (US); LACHENMANN, Susanne, D-52428 Jülich (DE)
(86) Internationale Anmeldenummer: DE9700462
(87) Internationale Veröffentlichungsnummer: WO9733303

(56) Entgegenhaltungen:
- EP-A- 0 496 259
- PHYSICAL REVIEW LETTERS, 3 JUNE 1985, USA, Bd. 54, Nr. 22, ISSN 0031-9007, Seiten 2449-2452, XP002036771 TAKAYANAGI H ET AL: "Superconducting proximity effect in the native inversion layer on InAs"

## Beschreibung

Die Erfindung bezieht sich auf ein elektronisches Bauteil, das zwei Oberflächen aufweist, die durch eine Flanke stufenförmig voneinander getrennt sind. Auf jeder der beiden Oberflächen ist eine Schicht aus supraleitfähigem Material aufgebracht. Die supraleitfähigen Schichten sind mittels der Flanke schwach miteinander gekoppelt.

Ein solches elektronisches Bauteil wird in der amerikanischen Anmeldung US 08/564,965, angemeldet am 30.11.1995, beschrieben.

Das in dieser Anmeldung beschriebene elektronische Bauteil besteht aus einer Kombination von Supra- und Halbleitern. Supraleitende Elektroden sind über den Halbleiter schwach gekoppelt. Diese Kopplung wird als "weak-link-Kontakt" bezeichnet.

Das beschriebene Bauteil weist zwei Oberflächen auf, die im folgenden Stufenoberflächen genannt werden. Die eine Stufenoberfläche ist durch eine senkrecht zu den Oberflächen ansteigende Flanke, also stufenförmig von der anderen Oberfläche getrennt. Auf jeder der beiden Stufenoberflächen ist eine Schicht aufgebracht, die bei geeignet tiefen Temperaturen über supraleitende Eigenschaften verfügt. Die Flanke bleibt unbeschichtet. Die beiden supraleitfähigen Schichten sind elektrisch über die Flanke der Treppenstufe miteinander gekoppelt und zwar in Form eines weak-link-Kontaktes. Die Flanke dieser Stufe besteht aus einem p-dotierten Halbleitermaterial zur Bildung des weak-link-Kontaktes. Das halbleitende Material besteht aus p-dotiertem Indiumarsenid. Die supraleitenden Schichten bestehen aus Niob. An der Flanke bildet sich infolge der p⁻-dotierten Schicht eine Inversionsrandschicht aus. In der Inversionsrandschicht findet die elektrische Leitung statt, die die schwache elektronische Kopplung bewirkt. Nachteilhaft weist dieses elektronische Bauelement einen hohen Normalwiderstand auf. Als Normalwiderstand wird der Widerstand des Bauteils für Spannungen oberhalb der doppelten Energielückenspannung des Supraleiters bezeichnet. Es hat sich gezeigt, daß bei einem elektronischen Bauteil mit Indiumarsenid als halbleitendem Material sowie auf der Treppe aufgebrachte Niobschichten mit einer Flanke der Höhe von 150 nm und einer Breite von 100 µm ein Normalwiderstand von 20 Ohm herrscht.

Je niedriger der Normalwiderstand ist, desto größer kann grundsätzlich die Stromstärke sein, die leistungslos bei tiefen Temperaturen fließen kann. Das Produkt aus Normalwiderstand und kritischer Stromstärke stellt grundsätzlich ein Maß für die Qualität des Bauelementes dar.

Aufgabe der Erfindung ist die Schaffung eines qualitativ verbesserten elektronischen Bauelementes der vorgenannten Art, bei dem ein Strom mit größerer Stromstärke im Vergleich zum aus US 08/564,965 bekannten Bauelement leistungslos fließen kann.

Die Aufgabe wird gelöst durch ein Bauelement mit den Merkmalen des Hauptanspruchs.

Unter einem Mittel zur Verbesserung des Elektronentransportes an zumindest einem der beiden Übergänge Oberfläche-Flanke ist jedes Mittel zu verstehen, welches den Elektronentransport zwischen einem der beiden Übergänge Oberfläche-Flanke fördert im Vergleich zu ei nem elektronischen Bauteil der aus US 08/564,965 bekannten Art, also einem Bauteil, bei dem die Stufe durch einen 90°-Winkel gebildet wird, bei dem ausschließlich p-dotiertes Halbleitermaterial zur Bildung der Stufe, insbesondere der Flanke, vorgesehen ist, bei dem auf den Stufenoberflächen supraleitfähige Schichten aufgebracht sind und bei dem ansonsten gleiche Abmessungen und gleiche Materialien vorgesehen sind.

Mittel zur Verbesserung des Elektronentransportes an zumindest einem der beiden Übergänge Oberfläche-Flanke liegen insbesondere dann vor, wenn durch dieses Mittel die kritische Stromstärke um zumindest einen Faktor 2, vorzugsweise um zumindest einen Faktor 10 im Vergleich zu einem Bauelement mit gleichen Abmessungen, einer ausschließlich p-dotierten, halbleitenden Flanke und einem 90°-Anstieg der Flanke heraufgesetzt wird.

Insbesondere ist als Mittel zur Verbesserung des Elektronentransportes an zumindest einem der beiden Übergänge Oberfläche-Flanke ein n-dotierter Bereich vorgesehen, der an zumindest eine Ecke der Stufe angrenzt. Unter Ecke einer Stufe wird der Übergang von der Oberfläche der Stufe zur Flanke oder aber der Übergang von der Flanke zur Oberfläche verstanden. Durch diese Dotierung wird die kritische Stromstärke sowie die Qualität des Bauelementes heraufgesetzt.

Vorteilhaft sind n⁺-dotierte Bereiche an beiden Ecken der Stufe vorgesehen. Zwischen den beiden Ecken der Stufe besteht keine n⁺-dotierte Verbindung, da andernfalls kein "weak-link"-Kontakt mehr vorliegen würde. Zur Bildung der Flanke ist daher vorzugsweise ein p⁻-dotierter Halbleiter vorgesehen, der die n⁺-dotierten Bereiche voneinander trennt. Die kritische Stromstärke sowie die Qualität des Bauelementes wird so weiter heraufgesetzt.

Hergestellt wird ein derartiges Bauteil z. B. folgendermaßen: Auf einem Substrat wird eine erste n⁺- oder n⁺⁺-dotierte Halbleiterschicht aufgebracht. Diese Halbleiterschicht ist 100 bis 500 nm, vorzugsweise 200 bis 300 nm dick. Hierauf wird eine p⁻-dotierte Halbleiterschicht aufgebracht. Diese ist vorzugsweise 50 bis 300 nm, insbesondere 100 bis 200 nm dick. Hierauf wird eine zweite n⁺- oder n⁺⁺-dotierte Halbleiterschicht aufgebracht, die vorzugsweise 10 bis 100 nm, insbesondere 40 bis 60 nm dick ist. In dieses Schichtsystem wird eine Stufe eingeätzt, die bis in die erste n-dotierte Halbleiterschicht beispielsweise 1 bis 30 nm hineinreicht. Auf die Stufenoberflächen wird nun supraleitendes Material schichtförmig mit einer Schichtdicke z. B. kleiner als 50 nm aufgebracht. Es liegt nun ein elektronisches Bauteil vor, welches einen n-dotierten Bereich aufweist, der an die Ecken der Stufe angrenzt. Die Ausdehnung dieses n-dotierten Bereiches beträgt, soweit er an die Flanke angrenzt, vorzugsweise 5 bis 50 nm, insbesondere 10 bis 20 nm. Die Flanke ist ansonsten insbesondere p⁻-dotiert.

Selbstverständlich können die genannten Mittel zur Verringerung des Normalwiderstandes auch vorteilhaft miteinander kombiniert werden.

Es hat sich experimentell gezeigt, daß mit derartigen Bauteilen der Normalwiderstand um einen Faktor 20 gesenkt werden kann.

Die Herabsetzung des Normalwiderstandes hat zur Folge, daß die kritische Stromstärke um zwei Größenordnungen heraufgesetzt wird.

Durch die Erfindung konnte ferner das Produkt um einen Faktor 5 heraufgesetzt und damit die Qualität des Bauteils wesentlich verbessert werden.

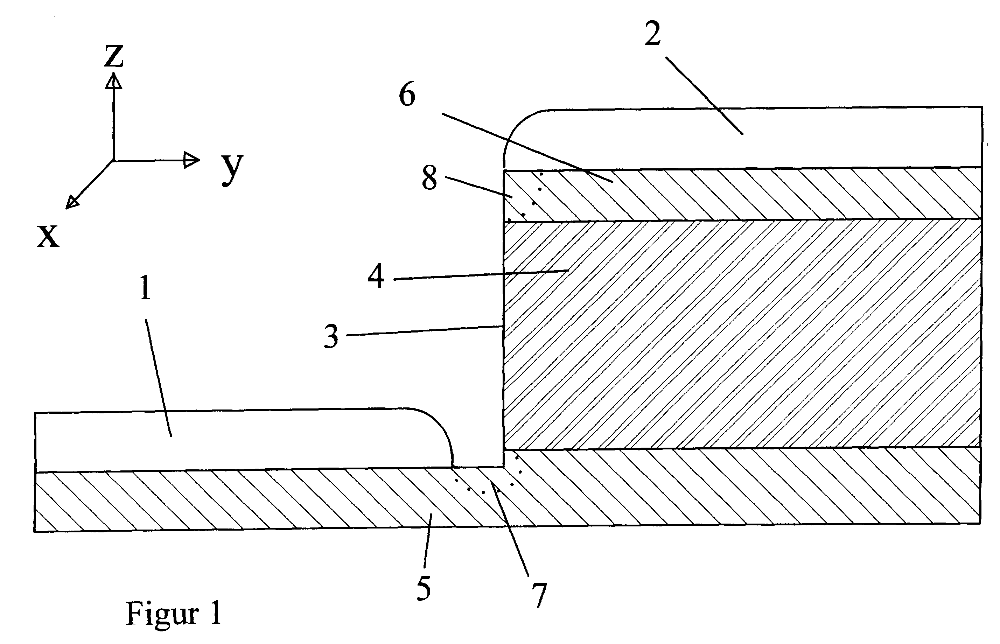

Die Figur zeigt eine Ausführungsform der Erfindung.

Das Bauelement weist zwei Oberflächen auf. Auf jeder der beiden Oberflächen ist eine ca. 60 nm dicke, aus Niob bestehende Schicht 1 und 2 aufgebracht. Die beiden Oberflächen sind durch eine Flanke 3 stufenförmig voneinander getrennt. Die Flanke 3 wird maßgeblich durch eine p⁻-dotierte Halbleiterschicht 4, bestehend aus InAs gebildet. Oberhalb und unterhalb der p⁻-dotierten Halbleiterschicht 4 befinden sich n⁺⁺-dotierte InAs-Halbleiterschichten 5 und 6. Die untere n⁺⁺-dotierte Schicht 5 ist so positioniert, daß es einen durch eine punktförmige Umrandung markierten Bereich 7 gibt, der an den Übergang von der Stufenoberfläche mit der Niob-Schicht 1 zur Flanke 3 angrenzt. Die obere n⁺⁺-dotierte Schicht bildet den Übergang von der Flanke 3 zur zweiten Oberfläche mit der Niob-Schicht 2. Auf diese Weise gibt es einen n⁺⁺-dotierten Bereich 8, der an diesen Übergang angrenzt.

Der Schichtenaufbau 7, 4, 8 erzeugt einen npn Kontakt in Aufwachsrichtung (z-Richtung) der Heterostruktur. Dieser npn Kontakt weist einen hohen Widerstand auf. Der Elektronentransport kann folglich im p⁻ -dotierten InAs nur in einem Oberflächenkanal entlang einer auf der Flanke befindlichen Inversionsrandschicht stattfinden. (InAs besitzt eine Inversionsrandschicht, welche den Charakter eines zweidimensionalen Elektronengases aufweist.) Mit supraleitenden Niob Kontakten auf dem oberen und unteren n⁺- Kanal arbeitet das Bauelement als SNS Josephson Kontakt, wobei die Kanallänge durch die Dicke der p-Schicht gegeben ist.

Experimentelle Ergebnisse haben gezeigt, daß durch den Übergang von der in der US-Anmeldung beschriebenen zu der erfindungsgemäßen Heterostruktur der kritische Strom I_{c} um einen Faktor 100 gesteigert und der Normalwiderstand Rₙ um einen Faktor 20 gesenkt werden konnte. (p⁺-p⁻ Struktur gemäß US-Anmeldung lieferte: I_{c} = 10 µA, Rₙ = 20 Ω; erfindungsgemäße n⁺p⁻n⁺ Struktur: I_{c} = 800 µA, Rₙ = 1 Ω bei einer Flankenlänge (Kanallänge) von 100 nm und einer Ausdehnung in x-Richtung von 100 µm). Die "Zick-Zack"-Geometrie (scharfe Umkehrpunkte im Kanal bzw. in der Stufe) ist für den hohen Normalwiderstand der Schaltungen verantwortlich. Mittel, die den elektrischen Widerstand, der durch diese Zick-Zack-Geometrie beim Elektronentransport verursacht wird, vermindern oder vermeiden und so den Elektronentransport beim Übergang von Stufenoberfläche zur Flanke verbessern, lösen folglich die Aufgabe. Als Mittel kommt daher nicht nur eine n⁺- oder n⁺⁺-Dotierung in diesem Bereich in Betracht, sondern auch z. B. eine Veränderung des Winkels, so daß der Übergang nicht mehr einem 90°-Winkel entspricht und weniger "spitz" verläuft. Gelöst wird die Aufgabe daher des weiteren auch durch z. B. einen "kurvenförmigen" Übergang von einer Flanke zur Oberfläche.

## Patentansprüche

1. Supraleiter/Halbleiter/Supraleiter-Stufenkontakt mit den Merkmalen:
- der Kontakt weist zwei Oberflächen auf,
- die Oberflächen sind durch eine p-dotierte Flanke (3) stufenförmig voneinander getrennt,
- auf jeder der beiden Oberflächen ist eine Schicht (1, 2) aus supraleitfähigem Material aufgebracht,
- die supraleitfähigen Schichten (1, 2) sind mittels der Flanke schwach miteinander gekoppelt,
**dadurch gekennzeichnet, daß**
- an zumindest einem der beiden Übergänge Oberfläche-Flanke ein n-dotierter, aus halbleitendem Material bestehender Bereich als Mittel zur Verbesserung des Elektronentransportes, der an zumindest einen der beiden Übergänge Oberfläche-Flanke angrenzt, vorgesehen ist.

## Claims

1. Super conductor/semiconductor/superconductor stepped contact having the following features:
- the contact has two surfaces,
- the surfaces are separated from one another in the shape of a step via a p-doped side edge (3),
- a layer (1, 2) of superconducting material is applied on each of the two surfaces,
- the superconducting layers (1, 2) are weakly coupled to one another by means of the side edge,
characterized in that
- at at least one of the two surface-side edge junctions, an n-doped region consisting of semiconductor material is provided as a means of improving electron transport, which adjoins at least one of the two surface/side edge junctions.

## Revendications

1. Contact étagé supraconducteur/semiconducteur/supraconducteur, présentant les caractéristiques:
- le contact comporte deux surfaces,
- les surfaces sont séparées d'une manière étagée l'une de l'autre par un flanc (3) dopé de type p,
- une couche (1,2) formée d'un matériau supraconducteur est déposée sur chacune des deux surfaces,
- les couches (1,2) pouvant être amenées à l'état supraconducteur sont couplées entre elles faiblement au moyen du flanc,
caractérisé en ce
qu'une zone dopée de type n, constituée par un matériau semiconducteur, et qui jouxte au moins l'une des deux jonctions surface-flanc, est prévue en tant que moyen pour améliorer le transport d'électrons, au niveau d'au moins l'une des deux jonctions surface-flanc.
